Europäisches Patentamt

European Patent Office

Office européen des brevets

(11) Veröffentlichungsnummer: **0 219 639 B1**

# EUROPÄISCHE PATENTSCHRIFT

(45) Veröffentlichungstag der Patentschrift: **25.09.91**

(51) Int. Cl.⁵: **H05K 9/00**

(21) Anmeldenummer: **86111319.9**

(22) Anmeldetag: **16.08.86**

(54) Hochfrequenzdichtes Gehäuse.

(30) Priorität: **23.10.85 DE 3537669**

(43) Veröffentlichungstag der Anmeldung:
**29.04.87 Patentblatt 87/18**

(45) Bekanntmachung des Hinweises auf die
Patenterteilung:
**25.09.91 Patentblatt 91/39**

(84) Benannte Vertragsstaaten:
**AT CH DE LI NL**

(56) Entgegenhaltungen:
**DE-B- 1 255 162**
**DE-U- 1 976 658**
**GB-A- 2 153 152**
**US-A- 3 534 146**

(73) Patentinhaber: **ROBERT BOSCH GMBH**
**Postfach 50**
**W-7000 Stuttgart 1(DE)**

(72) Erfinder: **Meissner, Udo, Dipl.-Ing.**
**Seehofstrasse 73**
**W-1000 Berlin 37(DE)**

(74) Vertreter: **Schmidt, Hans-Ekhardt**
**Robert Bosch GmbH Geschäftsbereich Elektronik Patent- und Lizenzabteilung Forckenbeckstrasse 9-13**
**W-1000 Berlin 33(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Beschreibung

## Stand der Technik

Die Erfindung geht von einem hochfrequenzdichten Gehäuse nach der Gattung des Anspruchs 1 aus.

Es sind längsgeteilte hochfrequenzdichte Gehäuse bekannt, die aus zwei Gehäuseschalen bestehen und in denen eine Leiterplatte mit elektrischen Bauelementen und Baueinheiten befestigt ist. Die Gehäuse weisen mindestens einen Einführstutzen für ein Koaxialkabel auf. Die Masseverbindung zwischen dem Außenleiter des Kabels, dem elektrisch leitenden Gehäuse und der Leiterplatte ist vom hochfrequenztechnischen Standpunkt aus gesehen für höhere Ansprüche nicht zufriedenstellend. Außerdem sind Aufbau und Montage des Gehäuses immer noch verhältnismäßig aufwendig.

Aus DE-B-1 255 162 ist ferner eine Abstimmvorrichtung mit einer Wanne bekannt, deren oberer Rand mindestens abschnittsweise nach außen gebogen ist und deren Deckel auf dem Wannenrand befestigt ist, wobei der Deckel auf der einen Seite scharnierartig in den Wannenrand eingehängt ist und der Deckelrand an dieser Seite nach innen gerichtete, den Wannenrand umgreifende Lappen aufweist und an der gegenüberliegenden Seite in dem Deckelrand Lappen so angeschnitten sind, daß sie abbiegbar sind, und daß diese Lappen unter den Wannenrand gebogen sind.

## Vorteile der Erfindung

Das erfindungsgemäße hochfrequenzdichte Gehäuse gemäß dem Anspruch 1 hat den Vorteil, daß die identisch ausgebildeten Gehäuseschalen leicht herstellbar und durch einfache Nietung zu einem Gehäuse vereinigbar sind und daß die Hochfrequenzdichtigkeit auch höheren Ansprüchen gerecht wird.

Durch die in den Unteransprüchen aufgeführten Maßnahmen sind vorteilhafte Weiterbildungen und Verbesserungen des im Anspruch 1 angegebenen hochfrequenzdichten Gehäuses möglich. Besonders vorteilhaft ist ein erfindungsgemäßes Gehäuse, bei dem das Gehäuse eine Leiterplatte enthält, die derart bemessen ist, daß ihre Ränder zwischen den Flanschen der beiden Gehäuseschalen eingeklemmt werden. Durch diese Maßnahme erhält man einen besonders guten induktionsarmen Kontakt zwischen dem Gehäuse und den mit dem Gehäusepotential zu verbindenden Leiterbahnen oder Leiterflächen der Leiterplatte.

Eine andere besonders vorteilhafte Weiterbildung des erfindungsgemäßen Gehäuses besteht darin, daß der Rohrstutzen an seinem gehäuseseitigen Ende eine Isolierstoff-Führungsscheibe für den Innenleiter des Koaxialkabels aufnimmt. Auf diese Weise wird eine besonders hochwertige Kontaktierung hergestellt.

## Zeichnung

Ausführungsbeispiele der Erfindung sind in der Zeichnung an Hand mehrerer Figuren dargestellt und in der nachfolgenden Beschreibung näher erläutert. Die Zeichnung zeigt in

Fig. 1 eine Ansicht einer erfindungsgemäßen Gehäuseschale,

Fig. 2 eine Schnittansicht der Gehäuseschale nach Fig. 1 gemäß dem Schnittverlauf II - II,

Fig. 3 eine Seitenansicht eines erfindungsgemäßen Gehäuses aus zwei zusammengesteckten Halbschalen gemäß den Fig. 1 und 2,

Fig. 4 einen Ausschnitt aus einem Gehäuse nach Fig. 3,

Fig. 5 einen Ausschnitt aus einem erfindungsgemäßen Gehäuse mit einem Flansch in einer anderen Ausführungsform,

Fig. 6 eine Schnittansicht eines erfindungsgemäßen Gehäuses mit einem rohrförmigen Stutzen,

Fig. 7 eine Ansicht einer Gehäuseschale des Gehäuses nach Fig. 5 mit einem rohrförmigen Stutzen und

Fig. 8 eine Ansicht einer Gehäuseschale des Gehäuses nach Fig. 5 in einer weiteren Ausführungsform.

## Beschreibung der Erfindung

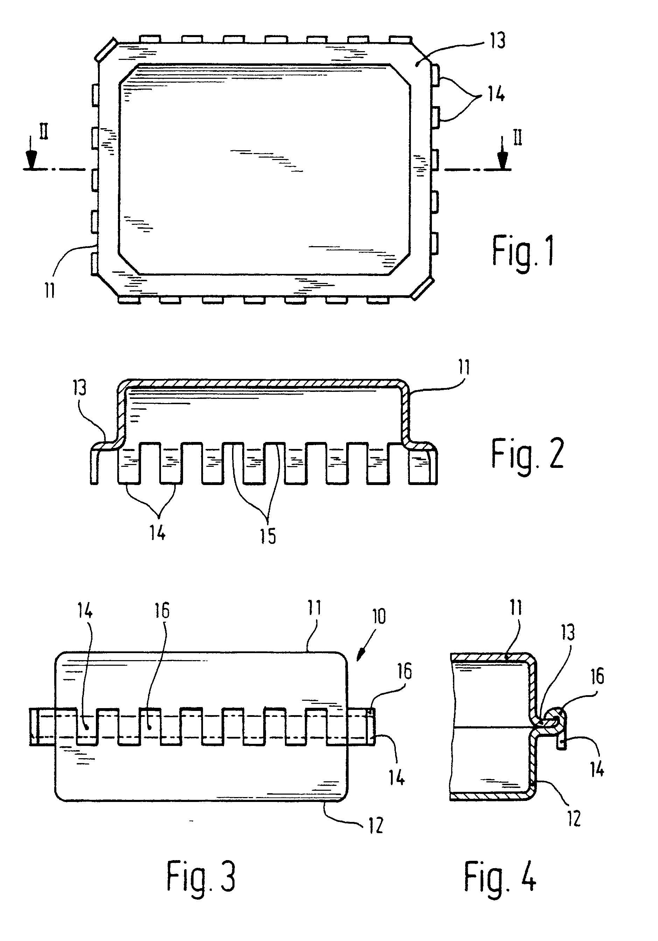

Nach den Fig. 1 bis 3 besteht ein quaderförmiges hochfrequenzdichtes Gehäuse 10 (Fig. 3) aus zwei identisch ausgebildeten Gehäuseschalen 11 und 12 aus einem metallischen oder metallisierten Werkstoff. Jede Gehäuseschale, zum Beispiel 11, weist an ihrem Rand einen umlaufenden Flansch 13 auf, der mit rechtwinklig zur Ebene des Flansches stehenden Zungen 14 versehen ist. Die Zahl der Zungen und deren gegenseitige Abstände sind so gewählt, daß die Zungen 14 der einen Gehäuseschale, zum Beispiel 11, in die Lücken 15 zwischen den Zungen 16 der anderen Gehäuseschale, zum Beispiel 12, passen. Die Gehäuseschalen 11 und 12 werden, wie in Fig. 3 gezeigt, zusammengesteckt und durch einfaches Umnieten der Zungen um den Flansch der jeweils anderen Gehäuseschale herum fest miteinander verbunden. Das Umnieten kann, wie in Fig. 4 gezeigt, auch als Bördelung ausgeführt werden. Nach Fig. 4 sind nur die Zungen 16 der unteren Gehäuseschale 12 umgebördelt, während die Zungen 14 der oberen Gehäuseschale weder gebördelt noch genietet sind. Auf diese Weise kommt man mit einem sehr einfachen Bördel- bzw. Nietwerkzeug aus.

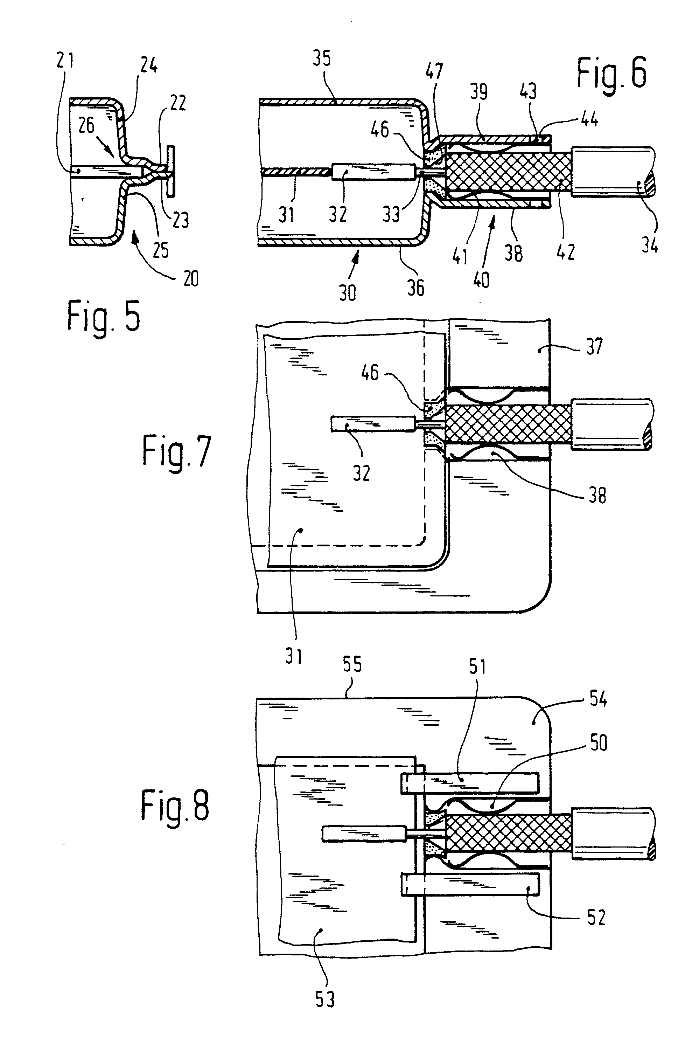

In dem Ausführungsbeispiel nach Fig. 5 ist ein Ausschnitt aus einem hochfrequenzdichten Gehäuse 20 gezeigt, das eine Leiterplatte 21 mit gedruckten bzw. geätzten Leiterbahnen und Leiterflächen und mit Bauteilen und Baueinheiten enthält. Zur Halterung der Leiterplatte innerhalb des Gehäuses 20 sind die Flansche 22, 23 der Gehäuseschalen 24, 25 derart abgestuft, daß eine umlaufende Tasche 26 entsteht, die den Rand der Leiterplatte 21 eng umschließt. Auf diese Weise werden im Randbereich der Leiterplatte vorhandene Leiterbahnen oder Leiterflächen mit dem Potential des Gehäuses 20 leitend verbunden.

Nach den Fig. 6 und 7 enthält ein Gehäuse 30 eine Leiterplatte 31, die einen Innenleiterkontakt 32 für den Innenleiter 33 eines Koaxialkabels 34 trägt. Die Gehäuseschalen 35, 36 weisen, wie in dem Ausführungsbeispiel nach Fig. 1, einen umlaufenden Flansch 37 (Fig. 7) auf, der an der Eintrittsstelle für das Koaxialkabel halbrohrförmige Stutzen 38, 39 enthält, die im zusammengesetzten Zustand des Gehäuses einen Rohrstutzen 40 bilden.

Der Rohrstutzen nimmt einen Federkorb 41 auf, der zur Kontaktierung des im Bereich des Federkorbes bis auf die Abschirmung 42 abisolierten Koaxialkabels dient. Der Federkorb 41 wird durch radial vorstehende Nasen 43, die in entsprechend geformte Öffnungen 44 des Rohrstutzen 40 passen, gegen ein axiales Verschieben und ein Verdrehen gesichert. An dem der Leiterplatte 31 zugewandten Ende des Rohrstutzens nimmt dieser eine Führungsscheibe 46 aus Isolierstoff auf. Diese Führungsscheibe dient zur Führung des im Bereich der Führungsscheibe freigelegten Innenleiters 33 des Koaxialkabels 34. Die Führungsscheibe weist eine nach außen sich konisch erweiternde Öffnung 47 auf. Der Innenleiter paßt in den als Steckbuchse ausgebildeten Innenleiterkontakt 32 der Leiterplatte 31, die, wie in Fig. 5 gezeigt, zwischen den Flanschen 37 eingeklemmt ist.

In einem weiteren Ausführungsbeispiel nach Fig. 8 sind zu beiden Seiten der halbrohrförmigen Stutzen 50 zwei schmale Metallbänder 51, 52 vorgesehen, deren eines Ende mit Leiterbahnen oder Leiterflächen der Leiterplatte 53 leitend verbunden sind und deren anderes Ende zwischen den Flanschen 54 der Gehäuseschalen 55 eingeklemmt werden und damit den elektrischen Kontakt mit dem Gehäuse 30 herstellen. Die Flansche 54 der beiden Gehäuseschalen sind an den Seiten, die mit einem Rohrstutzen versehen sind, ohne eine in Fig. 5 mit 26 bezeichnete Tasche ausgerüstet. Die Leiterplatte 53 endet deshalb auf der Seite der Rohrstutzen bereits vor dem Flansch 54.

## Patentansprüche

1. Hochfrequenzdichtes Gehäuse aus zwei iden-tisch geformten Gehäuseschalen, dadurch ge-kennzeichnet, daß die Gehäuseschalen (11, 12) an ihren einander zugekehrten Rändern mit einem umlaufenden Flansch (13) mit am Außenrand des Flansches vorgesehenen und rechtwinklig zur Ebene des Flansches ausgerichteten Zungen (14, 16) versehen sind, deren Zahl und Abstände derart gewählt sind, daß die Zungen (14) der einen Gehäuseschale (11) in die Lücken (15) zwischen den Zungen (16) der anderen Gehäuseschale (12) passen und sich nach einem Umnieten auf dem Flansch der anderen Gehäuseschale abstützen.

2. Hochfrequenzdichtes Gehäuse nach Anspruch 1, dadurch gekennzeichnet, daß das Gehäuse (20) eine Leiterplatte (21, 53) enthält, die derart bemessen ist, daß ihre Ränder zwischen den Flanschen (22, 23) der beiden Gehäuseschalen (24, 25) eingeklemmt werden.

3. Hochfrequenzdichtes Gehäuse nach Anspruch 2, dadurch gekennzeichnet, daß die Flansche (22, 23) nach außen derart abgesetzt sind, daß bei zusammengesetztem Gehäuse (20) eine umlaufende Tasche (26) zur Aufnahme der Ränder der Leiterplatte (21) entsteht.

4. Hochfrequenzdichtes Gehäuse nach einem der Ansprüche 1 bis 3, dadurch gekennzeichnet, daß die Gehäuseschalen (35, 36) mindestens einen halbrohrförmigen Stutzen (38, 39) aufweisen und daß die halbrohrförmigen Stutzen bei zusammengesetztem Gehäuse einen Rohrstutzen (40) zur Aufnahme eines Federkorbes (41) bilden, der ein bis auf die Abschirmung (42) abisoliertes Ende eines Koaxialkabels (34) aufnimmt.

5. Hochfrequenzdichtes Gehäuse nach Anspruch 4, dadurch gekennzeichnet, daß der Rohrstutzen (40) an seinem gehäuseseitigen Ende eine Isolierstoff-Führungsscheibe (46) für den Innenleiter (33) des Koaxialkabels (34) aufnimmt.

6. Hochfrequenzdichtes Gehäuse nach einem der Ansprüche 2 bis 5, dadurch gekennzeichnet, daß mindestens eine Leiterbahn oder Leiterfläche der Leiterplatte (53) mit einem Metallband (51) mechanisch und elektrisch verbunden ist und daß das freie Ende des Metallbandes zwischen die Flansche (54) der beiden Gehäuseschalen (55) geklemmt ist.

7. Hochfrequenzdichtes Gehäuse nach Anspruch 6, dadurch gekennzeichnet, daß die Leiterbahn oder Leiterfläche der Leiterplatte mit einem zweiten Metallband (52) verbunden ist, wobei je ein Metallband (51, 52) zu beiden Seiten des Rohrstutzens (40) vorgesehen ist.

**Claims**

1. High-frequency-impervious housing made of two identically formed housing shells, characterised in that housing shells (11, 12) are provided on their edges which face one another with a continuous flange (13) having tabs (14, 16), which are provided on the outer edge of the flange and are aligned at right angles to the plane of the flange, the number and spacing of which tabs are selected such that the tabs (14) of one housing shell (11) fit into the gaps (15) between the tabs (16) of the other housing shell (12) and are supported, following riveting over, on the flange of the other housing shell.

2. High-frequency-impervious housing as in claim 1, characterised in that the housing (20) contains a circuit board (21, 53), which is dimensioned in such a way that its edges are clamped between the flanges (22, 23) of the two housing shells (24, 25).

3. High-frequency-impervious housing as in claim 2, characterised in that the flanges (22, 23) are offset towards the outside in such a way that, when the housing (20) is assembled, a continuous pocket (26) is formed for receiving the edges of the printed circuit board (21).

4. High-frequency-impervious housing as in any of claims 1 to 3, characterised in that the housing shells (35, 36) have at least one semitubular shaped projection (38, 39), and, when the housing is assembled, the semitubular-shaped projections form a tubular projection (40) for receiving a springy cage (41), which accommodates an end of a coaxial cable (34), which end is stripped of insulation down to the screen (42).

5. High-frequency-impervious housing as in claim 4, characterised in that on its end on the housing side the tubular projection (40) accommodates an insulating material guide disc (46) for the inner conductor (33) of the coaxial cable (34).

6. High-frequency-impervious housing as in any of claims 2 to 5, characterised in that at least one conductive track or conductive surface of the circuit board (53) is mechanically and electrically connected to a metal strip (51), and in that the free end of the metal strip is clamped between the flanges (54) of the two housing shells (55).

7. High-frequency-impervious housing as in claim 6, characterised in that the conductive track or conductive surface of the circuit board is connected to a second metal strip (52), whereby a respective metal strip (51, 52) is provided on each side of the tubular projection (40).

**Revendications**

1. Boîtier ne laissant pas passer la haute fréquence, constitué par deux coquilles de boîtier formées de façon identique, caractérisé en ce que les coquilles (11, 12) du boîtier comportent sur leurs bords situés en regard l'un de l'autre une bride (13) circulaire et sont pourvues de languettes (14, 16) prévues sur le bord extérieur de la bride et orientées à angle droit par rapport au plan de la bride, languettes dont le nombre et les écartements sont prévus de telle manière, que les languettes (14) de l'une (11) des coquilles du boîtier passent dans les vides (15) entre les languettes (16) de l'autre coquille (12) du boîtier et s'appuient après un rivetage sur la bride de l'autre coquille du boîtier.

2. Boîtier ne laissant pas passer la haute fréquence selon la revendication 1, caractérisé en ce que le boîtier (20) contient une plaquette de circuits imprimés (21, 53), qui est dimensionnée de telle manière, que ses bords sont enserrés entre les brides (22, 23) des deux coquilles (24, 25) du boîtier.

3. Boîtier ne laissant pas passer la haute fréquence selon la revendication 2, caractérisé en ce que les brides (22, 23) sont décalées en retrait vers l'extérieur de telle manière, que lorsque le boîtier (20) est assemblé, il en résulte une poche (26) circulaire pour recevoir les bords de la plaquette de circuits imprimés (21).

4. Boîtier ne laissant pas passer la haute fréquence selon l'une des revendications 1 à 3, caractérisé en ce que les coquilles (35, 36) du boîtier sont pourvues d'au moins un ajutage (38, 39) de forme semi-tubulaire, et en ce que ces ajutages de forme semi-tubulaire forment, lorsque le boîtier est assemblé, une tubulure (40) pour recevoir une cage élastique (41), qui reçoit une extrémité dénudée, jusqu'au blindage (42), d'un câble coaxial (34).

5. Boîtier ne laissant pas passer la haute fréquence selon la revendication 4, caractérisé en ce que la tubulure (40) reçoit, à son extrémité située du côté du boîtier, un disque de guidage (46) en matière isolante pour le conducteur intérieur (33) du câble coaxial (34).

6. Boîtier ne laissant pas passer la haute fréquence selon l'une des revendications 2 à 5, caractérisé en ce qu'au moins une voie conductrice ou surface conductrice de la plaquette de circuits imprimés (53) est reliée mécaniquement et électriquement à une bande métallique (51), et en ce que l'extrémité libre de la bande métallique est enserrée entre les brides (54) des deux coquilles (55) du boîtier.

7. Boîtier ne laissant pas passer la haute fréquence selon la revendication 6, caractérisé en ce que la voie conductrice ou surface conductrice de la plaquette de circuits imprimés est reliée à une seconde bande métallique (52), une bande métallique (51, 52) étant prévue sur chacun des deux côtés de la tubulure (40).

Fig. 1

Fig. 2

Fig. 3

Fig. 4

Fig. 5

Fig. 6

Fig. 7

Fig. 8